# EUROPEAN PATENT SPECIFICATION

(11) **EP 2 190 116 B1**
(45) Date of publication and mention of the grant of the patent: **21.03.2018**
(21) Application number: 08783933.8
(22) Date of filing: 11.08.2008
(51) Int. Cl.: H03H 7/24, H01C 1/16, H01C 13/02

(54) **VARIABLE ATTENUATOR**
VARIABLES DÄMPFUNGSGLIED
ATTÉNUATEUR VARIABLE

(30) Priority: 11.08.2007 CN 200710075714; 31.10.2007 CN 200710124352; 20.11.2007 CN 200710193881; 05.02.2008 CN 200810080717
(43) Date of publication of application: 26.05.2010
(73) Proprietor: Yantel Corporation, Shenzhen 518045 (CN)
(72) Inventor: Yan, Yuejun, Shenzhen, Guangdong 518045 (CN); Yan, Yuepeng, Shenzhen, Guangdong 518045 (CN)
(74) Representative: Hryszkiewicz, Danuta
(86) International application number: PCT/CN2008/071940
(87) International publication number: WO 2009/021449

(56) References cited:
- EP-A1- 1 804 329
- CN-A- 1 111 417
- CN-A- 1 380 748
- CN-A- 1 674 351
- CN-A- 101 079 606
- JP-A- H1 098 306
- JP-A- H10 242 711
- JP-A- 2000 261 209
- US-A- 3 184 694
- US-A- 4 086 548
- US-A- 5 339 065
- US-A1- 2004 233 011
- ANDERSON A K ET AL: "Generic constant phase digital attenuators", 19940101, January 1994 (1994-01), pages 11/1-11/7, XP006527377,

## Description

The invention relates to an attenuator, and more particularly to a variable attenuator.

In the family of electronic components, the variable attenuator is one of the common and basic components in electrical circuits and systems. The existence of a variable attenuator makes the fabrication of electrical circuits and the debugging of systems more flexible and convenient. Currently, the variable attenuator is being widely used in circuits and systems with operating frequencies below several hundred megahertz (MHz).
ANDERSON A K, et al. "Generic constant phase digital attenuators," January 1994, pages 11/1 - 11/7, XP006527377, discloses variable attenuators which utilize FETs as switches.
JP200026109A discloses a π-type variable attenuator including a main line 3 formed on a dielectric substrate 1, two branch lines 4 and 7 which have front end opened, two pads 5 and 8 which are grounded and face the respective front ends of the two branch lines 4 and 7, two film resistances 10 and 11 provided between the branch lines 4 and 7 and the two pads 5 and 8, respectively, and a film resistance 12 provided in the main line 3. The π-type variable attenuator further includes jumper wires 13 for connecting the film resistances 10 and 11 and the pads 5 and 8, respectively or for short circuiting the film resistance 12.
US4086548A discloses a switchable attenuator which utilizes a plurality of rocker arms 40a-40f as parallel switches and serial switches.
EP1804329A1 discloses a variable attenuator which utilizes conductive sheets 3 and 4 for continuously changing the resistances of the film resistors 1 and 2.

Variable attenuators normally provide continuous attenuation values in a fixed range, however, in some cases, users only need some fixed values of the continuous attenuation values. In the prior art, a stepped variable attenuator is formed by cascading a variable attenuator with one or more passive fixed attenuators, and a signal line is disposed between the attenuators. Switching between the attenuator and the signal line is implemented via a switch. As a signal passes the signal line and does not pass the attenuator, attenuation is zero, otherwise a stepped attenuation exists. This method implements variation of attenuation by switching a main signal circuit. However, during the switching process, especially mechanical or manual switching, a strong reflection signal (a burst pulse) may occur on the main signal circuit and damage a power tube of a previous stage. Moreover, there is another method that disables one or more passive fixed attenuators via conductive sheets or electric switches, whereby implementing stepped adjustment of the variable attenuator. However, this method does not completely separate the attenuator from the main signal circuit, and thus cannot implement variation of attenuation.

In view of the above-described problem, it is one objective of the invention to provide a variable attenuator capable of addressing problems with the variable attenuator that a strong reflection signal may occur on the main signal circuit during switching of the main signal circuit, and the attenuator cannot be completely separated from the main signal circuit and thus variation of attenuation cannot be easily implemented.

To achieve the above objectives, provided is a variable attenuator, as defined in the appended claims.

A variable attenuator may comprise at least one-stage attenuator circuit, comprising a signal input end, a signal output end, and a common grounded end, a first serial resistor being disposed between the signal input and the signal output end whereby forming a main signal circuit, and a first parallel resistor being connected between the main signal circuit and the common grounded end. The attenuator circuit further comprises a first parallel switch parallel connected to the first serial resistor, and a first serial switch serially connected to the first parallel resistor.

In another example provided is a variable attenuator, comprising at least one-stage bridge-type attenuator circuit, comprising a signal input end, a signal output end, a common grounded end, a serial resistor being disposed between the signal input and the signal output end whereby forming a main signal circuit, a pair of bridge-arm resistors being connected to both ends of the serial resistor, one end of each of the bridge-arm resistors being connected to the serial resistor, a parallel resistor being disposed between the node and the common grounded end. The attenuator circuit further comprises a parallel switch parallel connected to the serial resistor, and a serial switch serially connected to the parallel resistor.

With the parallel switch parallel connected to the serial resistor, and the serial switch serially connected to the parallel resistor, as the parallel switch is switched on to eliminate attenuation on a certain stage, the serial switch is switched off, whereby preventing the parallel resistor from affecting the main signal circuit and ensuring stable attenuation with higher precision and a wider frequency range; moreover, switching of the main signal circuit is not required, which ensures that a signal is always transmitted on the main signal circuit and no reflection signal (burst pulse) is generated on the main signal circuit, and thus a circuit on a previous stage will not be damaged.
FIG. **1** is a schematic diagram of a variable attenuator of a first embodiment of the invention;
FIG. **2** is a schematic view of a surface layer of a substrate of a variable attenuator of a first embodiment of the invention;
FIG. **3** is a schematic view of a bottom layer of a substrate of a variable attenuator of a first embodiment of the invention;
FIG. **4** is a schematic view of a switch of a variable attenuator of a first embodiment of the invention;
FIG. **5** illustrates a combination of a switch in FIG. **4** with a substrate;
FIG. **6** is a schematic diagram of a variable attenuator of a second embodiment of the invention;
FIG. **7** is a schematic view of a surface layer of a first substrate of a variable attenuator of a second embodiment of the invention;
FIG. **8** is a schematic view of a surface layer of a first switch of a variable attenuator of a second embodiment of the invention;
FIG. **9** is a schematic view of a bottom layer of a first switch of a variable attenuator of a second embodiment of the invention;
FIG. **10** illustrates a first combination of a first switch in FIG.S. **8** and **9** with a surface layer of a first substrate;
FIG. **11** illustrates a second combination of a first switch in FIG.S. **8** and **9** with a surface layer of a first substrate;
FIG. **12** is a schematic view of a surface layer of a second substrate of a second embodiment of the invention;
FIG. **13** is a schematic view of a surface layer of a second switch of a variable attenuator of a second embodiment of the invention;
FIG. **14** is a schematic view of a bottom layer of a second switch of a variable attenuator of a second embodiment of the invention;
FIG. **15** illustrates a first combination of a second switch in FIGS. **13** and **14** with a surface layer of a second substrate;
FIG. **16** illustrates a second combination of a second switch in FIGS. **13** and **14** with a surface layer of a second substrate;
FIG. **17** is a schematic diagram of a variable attenuator of a third embodiment of the invention;
FIG. **18** is a schematic diagram of a variable attenuator in FIG. **17** with a correcting circuit;
FIG. **19** is a schematic diagram of a variable attenuator of a fourth embodiment of the invention;
FIG. **20** is a schematic view of a surface layer of a substrate of a variable attenuator of a fourth embodiment of the invention;
FIG. **21** is a schematic view of a bottom layer of a substrate of a variable attenuator of a fourth embodiment of the invention;
FIG. **22** is a schematic view of a switch of a variable attenuator of a fourth embodiment of the invention;
FIG. **23** illustrates a combination of the switch in FIG. **22** with a substrate;
FIG. **24** is a schematic diagram of a variable attenuator of a fifth embodiment of the invention;
FIG. **25** is a schematic diagram of a variable attenuator of a sixth embodiment of the invention;
FIG. **26** is a schematic view of a surface layer of a substrate of a variable attenuator of a sixth embodiment of the invention;
FIG. **27** is a schematic view of a switch of a variable attenuator of a sixth embodiment of the invention;
FIG. **28** illustrates a combination of the switch in FIG. **27** with a substrate;
FIG. **29** is a schematic view of a surface layer of a substrate of a variable attenuator of a seventh embodiment of the invention;
FIG. **30** is a schematic view of a bottom layer of a substrate of a variable attenuator of a seventh embodiment of the invention;
FIG. **31** is a schematic view of a switch of a variable attenuator of a seventh embodiment of the invention;
FIG. **32** illustrates a combination of the switch in FIG. **31** with a substrate;
FIG. **33** is a schematic view of a surface layer of a substrate of a variable attenuator of an eighth embodiment of the invention;
FIG. **34** is a schematic view of a bottom layer of a substrate of a variable attenuator of an eighth embodiment of the invention;
FIG. **35** is a schematic view of a switch of a variable attenuator of an eighth embodiment of the invention;
FIG. **36** illustrates a combination of the switch in FIG. **35** with a substrate;
FIG. **37** is a schematic view of a coaxial connector with a metal housing;
FIG. **38** is an exploded view of a coaxial connector in FIG. **37**; and
FIG. **39** is a schematic view of an integral coaxial connector.

For clear understanding of an objective, solution and advantages of the invention, detailed description will be given below in conjunction with accompanying drawings. It should be understood that specific embodiments described herein only intend to explain the invention, not to limit the scope of the invention.

In the invention, parallel switches are parallel connected to serial resistors in different stages of an attenuator circuit, and serial switches are serially connected to any one end of each parallel resistor, as the parallel switches are switched on to eliminate attenuation of a certain stage, the serial switch is switched off whereby preventing the parallel switch from affecting a main signal circuit.

In the invention, the attenuator circuit can be any typical attenuator circuit, such as a π-type attenuator circuit, a T-type attenuator circuit, a bridge-type attenuator circuit, and so on.

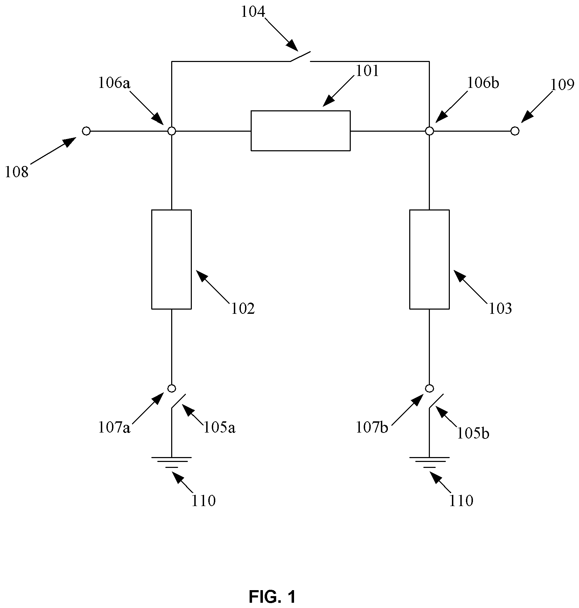

As shown in FIG. **1**, a schematic diagram of a variable attenuator of a first embodiment of the invention is shown.

For a typical π-type attenuator circuit, a first parallel switch **104** is parallel connected between both terminals **106a** and **106b** of a first serial resistor **101.** A serial resistor refers to a resistor connected between a signal input end and a signal output end of the variable attenuator and forming a main signal circuit, and a parallel refers to a resistor having an end connected to the main signal circuit directly or via other components, and another end connected to a common grounded end of the variable attenuator. The parallel resistor and the serial resistor are chip resistors, thick film resistors, thin film resistors, embedded resistors, printed resistors, or combinations thereof. A first serial switch **105a** is serially connected between a first parallel resistor **102** and a common grounded end **110.** A second serial switch **105a** is serially connected between a second parallel resistor **103** and the common grounded end **110.** As the first parallel switch **104** is switched off and the first serial switch **105a** and the second serial switch **105b** are switched on, the variable attenuator is a π-type attenuator circuit having required attenuation. As the first parallel switch **104** is switched on and the first serial switch **105a** and the second serial switch **105b** are switched off, attenuation of the variable attenuator is 0dB, and thus variation of attenuation of the variable attenuator is implemented. At this time, the first parallel resistor **102** and the second parallel resistor **103** can be regarded as being hang on the main signal circuit. However, since the first parallel resistor **102** and the second parallel resistor **103** are in a high-resistance state for a RF circuit, their effect on the main signal circuit is neglectable.

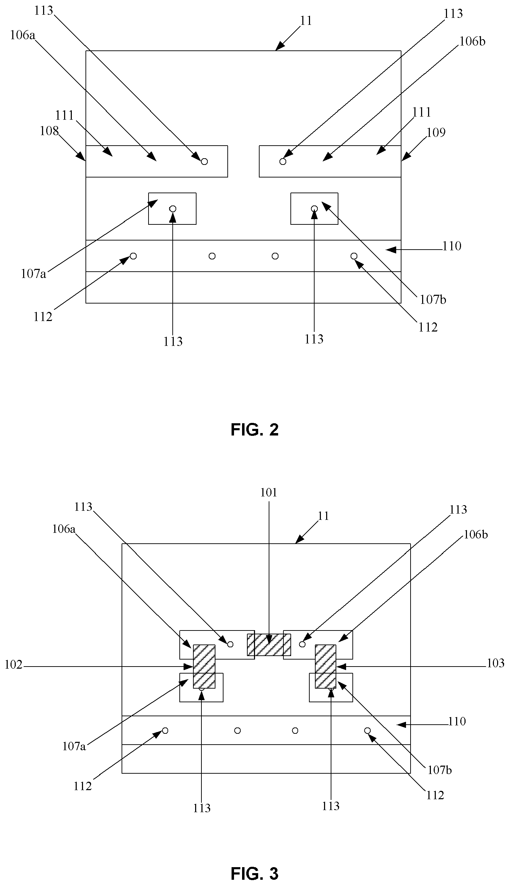

As shown in FIG. **2**, a schematic view of a surface layer of a substrate of a variable attenuator of a first embodiment of the invention. It should be noted that only parts of components relevant to this embodiment are illustrated for the purpose of clear explanation.

In this embodiment, a substrate **11** is a RF PCB board. In other embodiment, the substrate **11** can be a ceramic substrate with better heat dissipation and heat tolerance performance. For convenient adjusting and layout, and easy transmission of RF signals, in this embodiment, substrate **11** is a four-layer PCB board. In other embodiment, other number of layers, such as one, two or more may be used. A first layer of the substrate **11** is a surface layer, and a signal input end **108,** a signal output end **109**, a signal microstrip line **111**, both terminals **106a** and **106b** of the first serial resistor **101**, an terminal **107a** of the first parallel resistor **102**, an terminal **107b** of the second parallel resistor **103**, and the common grounded end **110** are disposed on the surface layer. Two intermediate layers are metal grounded layers, and are connected to the common grounded end **110** on the surface layer and the bottom layer via a grounded through hole **112**. The signal input end **108** is connected to the terminal **106a** via the signal microstrip line **111**, the terminal **106a** is connected to the terminal **106a** on the bottom layer via a signal through hole **113**, the signal output end **109** is connected to the terminal **106b** via the signal microstrip line **111**, the terminal **106b** is connected to the terminal **106b** on the bottom layer via the signal through hole **113**, the ends **107a** and **107b** are respectively connected to the ends **107a** and **107b** on the bottom layer via the signal through hole **113**, and the signal through hole **113** is not connected to the metal grounded layers. The first serial resistor **101**, the first parallel resistor **102**, and the second parallel resistor **103** are disposed on the bottom layer.

As shown in FIG. **3**, a schematic view of a bottom layer of a substrate of a variable attenuator of a first embodiment of the invention is shown. It should be noted that only parts of components relevant to this embodiment are illustrated for the purpose of clear explanation.

A first serial resistor **101** is disposed on a bottom layer of a substrate **11.** Both ends of the first serial resistor **101** are connected to ends **106a** and **106b** on the bottom layer. A first parallel resistor **102** and a second parallel resistor **103** are disposed on the bottom layer of the substrate **11**. One end of the first parallel resistor **102** is connected to the terminal **106a**, and the other end thereof is connected to the terminal **107a**. One end of the second parallel resistor **103** is connected to the terminal **106b**, and the other end thereof is connected o the terminal 107b. To prevent solder tin or welding oil penetrating a signal through hole 113 or a grounded through hole 112 from affecting terminals on the surface layer during automatic welding, solder mask is used to cover the signal through hole 113 or the grounded through hole 112.

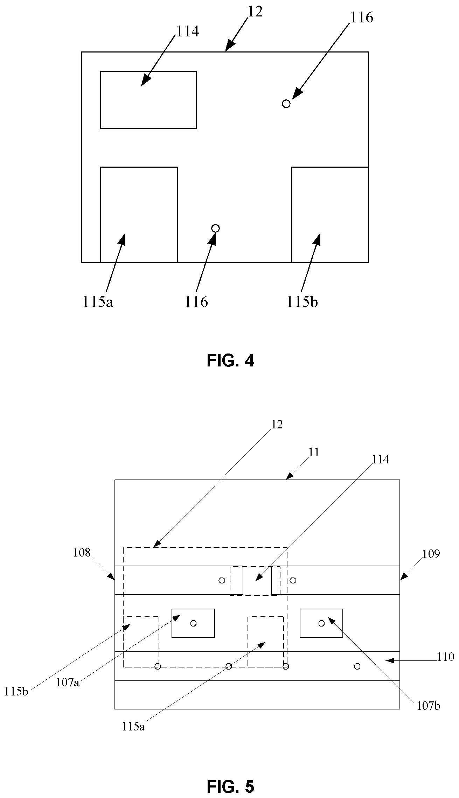

As shown in FIG. 4, a schematic view of a switch of a variable attenuator of a first embodiment of the invention is shown.

The switch of the variable attenuator is a toggle switch implemented via a conductive sheet, so as to save cost and to make it possible for the first parallel resistor, the second parallel resistor and the first serial resistor to be smoothly connected to the main signal circuit as the first parallel switch, the first serial switch and the second serial switch are switched. A width of the conductive sheet is the same as a bandwidth whereby obtaining an optimum attenuation. In another embodiment, the switch may be a rotary switch implemented by a conductive sheet. The conductive sheets are made of conductive materials such as conductors, and disposed on the same insulator **12** so that the first parallel switch, the first serial switch and the second serial switch operate simultaneously. In another embodiment, the first parallel switch, the first serial switch and the second serial switch are disposed on different insulators. The insulator **12** is a single-layered PCB board, but not limited to the PCB board. In other embodiments, the insulator **12** is made of plastics, ceramics and so on. Three conductive sheets **114**, **115a** and **115b** are disposed on the insulator **12**. The conductive sheet **114** operates as a switch of the first serial resistor **101**, the conductive sheet **115a** operates as a switch of the first parallel resistor **102**, and the conductive sheet **115b** operates as a switch of the second parallel resistor **103**. A transition hole **116** operates to move the PCB board.

As shown in FIG. **5**, a combination of a switch in FIG. **4** with a substrate is shown.

A first parallel switch, a first serial switch and a second serial switch on the PCB board, and a first parallel resistor, a second parallel resistor and a first serial resistor on the bottom layer of the substrate can be disposed on the same layer or different layers. In this embodiment, the first parallel switch, the first serial switch and the second serial switch on the PCB board, and the first parallel resistor, the second parallel resistor and the first serial resistor on the bottom layer of the substrate are disposed on different layers. As shown in FIGS. **1** and **5**, a part indicated by a dashed line illustrates a PCB board in FIG. **4** (rotating by **180** degrees) on the substrate **11**. A side of the PCB board on which the metal conductive sheet is disposed is contacted with the surface layer of the substrate **11**. The first serial resistor **101** is shortened by the conductive sheet **114**, namely the first parallel switch **104** parallel connected to the first serial resistor **101** in FIG. **1** is switched on. At this time, the conductive sheets **115a** and **115b** are not contacted with the terminals **107a** and **107b**, namely the first serial switch **105a** and the second serial switch **105b** respectively serially connected to the first parallel resistor **102** and the second parallel resistor **103** are switched off, and attenuation of the variable attenuator is 0dB. When moving the PCB board **12** so that the conductive sheet **114** detaches from the terminal **106a** of the first serial resistor **101**, namely the first parallel switch **104** parallel connected to the first serial resistor **101** is switched off, the conductive sheet **115a** connects the terminal **107a** to the common grounded end **110**, namely the first serial switch **105a** serially connected to the first parallel resistor **102** is switched on, and the conductive sheet **115b** connects the terminal **107b** to the common grounded end **110**, namely the second serial switch **105a** serially connected to the second parallel resistor **103** is switched on. At this time, attenuation of the variable attenuator is equal to a predetermined value, and thus variation of the attenuation is realized, and the process is reversible.

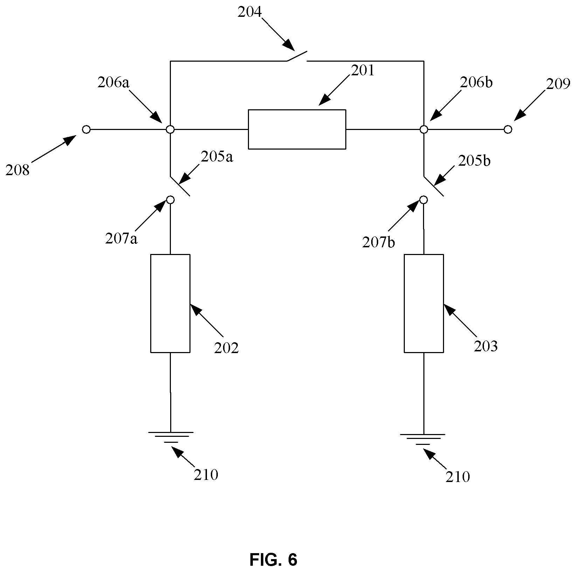

As shown in FIG. **6**, a schematic diagram of a variable attenuator of a second embodiment of the invention is shown.

Difference from FIG. **1** is that a first serial switch **205a** is not disposed between a first parallel resistor **202** and a common grounded end **210**, but on the other end of the first parallel resistor **202**, and a second serial switch **205b** is not disposed between a second parallel resistor **203** and the common grounded end **210**, but on the other end of the second parallel resistor **203**, whereby facilitating variation of attenuation of the variable attenuator.

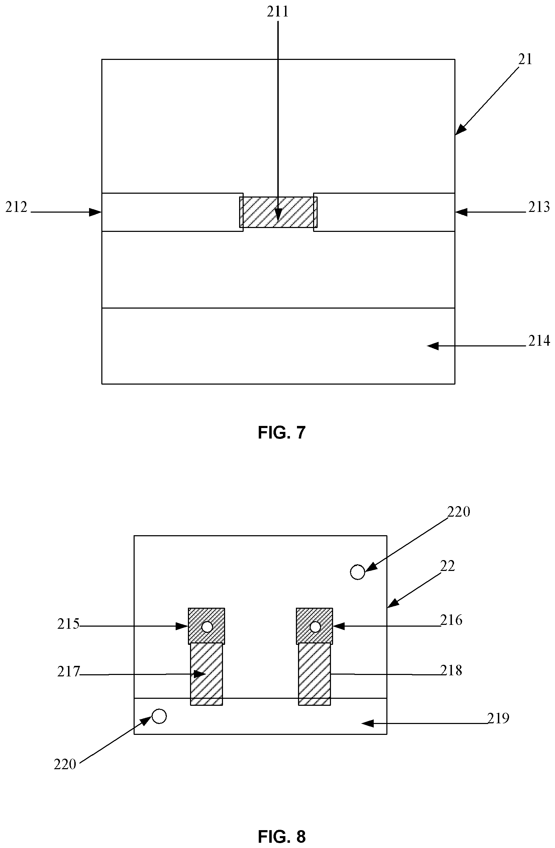

As shown in FIG. **7**, a schematic view of a surface layer of a first substrate of a variable attenuator of a second embodiment of the invention is shown, it should be noted that only parts of components relevant to this embodiment are illustrated for the purpose of clear explanation.

In this embodiment, an attenuation circuit is disposed on a substrate **21**, and an insulator operating as a switch. In this embodiment, the substrate **21** is a ceramic substrate that features good RF performance and heat tolerance performance and makes it possible to dispose a film resistor (a thin film resistor or a thick film resistor) thereon. In other embodiments, other types of substrates can be used. A first serial resistor **211** and a common grounded end **214** are disposed on the substrate **21**, and both ends of the first serial resistor **211** are respectively connected to a signal input end **212** and a signal output end **213**. A thickness of the first serial resistor **211** is slightly less than that of a signal microstrip line. In another embodiment, the first serial resistor **211** is disposed on a bottom layer of the substrate **21**.

As shown in FIG. **8**, a schematic view of a surface layer of a first switch of a variable attenuator of a second embodiment of the invention is shown. It should be noted that only parts of components relevant to this embodiment are illustrated for the purpose of clear explanation.

In order to improve precision of the variable attenuator and to reduce effect of the first parallel resistor **217** and the second parallel resistor **218** on the main signal circuit, the first parallel resistor **217**, the second parallel resistor **218** and a pair of conductive sheet **215** and **216** are disposed on the same insulator **22**. The insulator **22** is a double-layered ceramic substrate having better heat dissipation performance than a PCB board. In other embodiment, the insulator **22** is made of plastic rubber, a PCB board and so on. The first parallel resistor **217** and the second parallel resistor **218** are disposed on a surface layer of the ceramic substrate, the conductive sheet **215** operating as a first serial switch is connected to one end of the first parallel resistor **217**, the conductive sheet **216** operating as a second serial switch is connected to one end of the second parallel resistor **218**. The other end of the first parallel resistor **217** and that of the second parallel resistor **218** are connected to the common grounded end **219**.

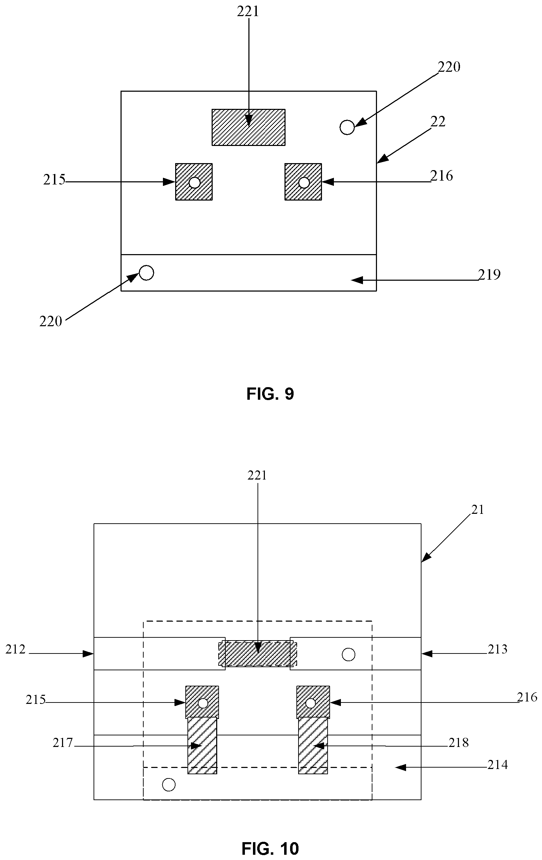

As shown in FIG. **9**, a schematic view of a bottom layer of a first switch of a variable attenuator of a second embodiment of the invention is shown, and it is a top view of FIG. **8**.

Multiple conductive sheets **221**, **215** and **216**, and a transition hole **220** are disposed on a bottom layer of the ceramic substrate. The conductive sheet **221** operates to shorten the first serial resistor **211**, and the conductive sheets **215** and **216** are connected to the ceramic substrate via through holes **220**.

As shown in FIG. **10**, a first combination of a first switch in FIGS. **8** and **9** with a surface layer of a first substrate is shown.

The bottom layer of the ceramic substrate is contacted with a surface layer of the substrate **21** in FIG. **7**. The conductive sheet **221** shortens the first serial resistor **211**, and the first parallel resistor **217**, the second parallel resistor **218**, the first serial switch **215**, and the second serial switch **216** are disconnected from the main signal circuit. At this time, attenuation of the variable attenuator is 0 dB.

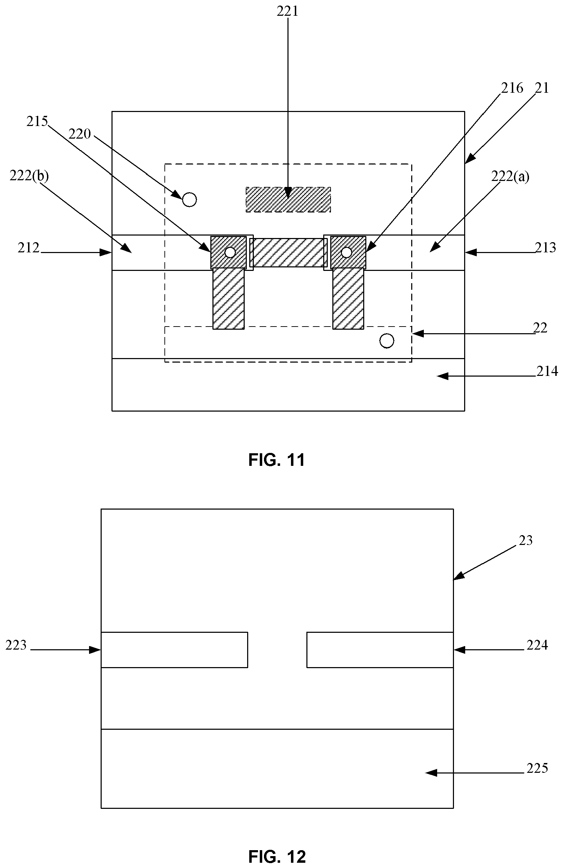

As shown in FIG. **11**, a second combination of a first switch in FIGS. **8** and 9 with a surface layer of a first substrate is shown.

By moving the ceramic substrate via the transition hole **220** so that the conductive sheet **221** detaches from the first serial resistor **211**. At this time one end of the conductive sheet **215** is connected to a signal microstrip line **222(b)** of the substrate **21** and to one end of the first serial resistor **211**, one end of the conductive sheet **216** is connected to another signal microstrip line **222(a)** of the substrate **21** and to the other end of the first serial resistor **211**, and thus a π-type attenuator circuit is formed.

As shown in FIG. **12**, a schematic view of a surface layer of a second substrate of a second embodiment of the invention. It should be noted that only parts of components relevant to this embodiment are illustrated for the purpose of clear explanation.

In this embodiment, an attenuation circuit is disposed on a substrate **23**, and an insulator operating as a switch. In this embodiment, the substrate **23** is a ceramic substrate that features good RF performance and makes it possible to dispose a film resistor (a thin film resistor or a thick film resistor) thereon. In other embodiments, other types of substrates can be used. A signal input end **223**, a signal output end **224**, and a common grounded end **225** are disposed on the substrate **23**.

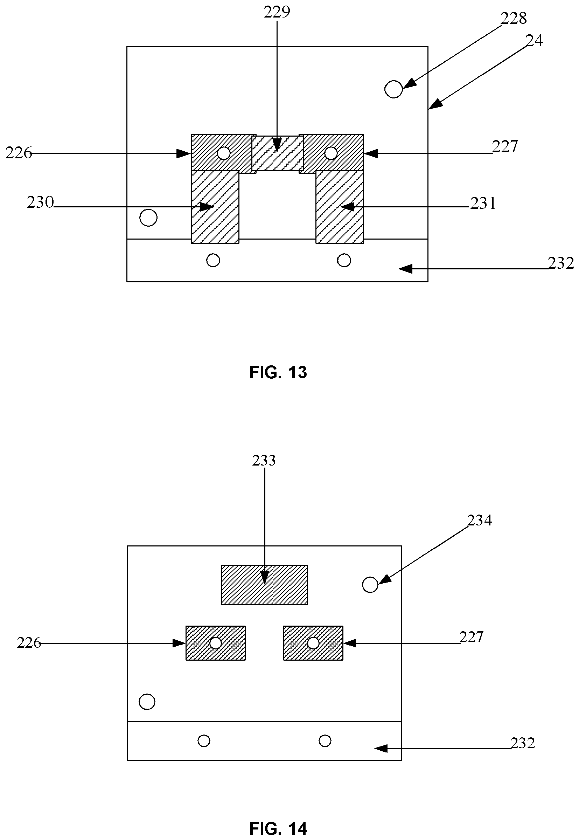

As shown in FIG. **13**, a schematic view of a surface layer of a second switch of a variable attenuator of a second embodiment of the invention is shown. It should be noted that only parts of components relevant to this embodiment are illustrated for the purpose of clear explanation.

The first parallel resistor, the second parallel resistor, the first serial resistor, and a pair of conductive sheet and are disposed on the same insulator **24**. The insulator **24** is a double-layered ceramic substrate or PCB board. In other embodiment, the insulator **24** is made of plastic rubber. The first parallel resistor **230**, the second parallel resistor **231**, and the first serial resistor **229** are disposed on a surface layer of the insulator **24**, one end of the first parallel resistor **230** is connected to the conductive sheet **226**, one end of the second parallel resistor **231** is connected to the conductive sheet **227**, the other end of the first parallel resistor **230** and that of the second parallel resistor **231** are connected to the common grounded end **232**, and both ends of the first serial resistor **229** are respectively connected to the conductive sheets **226** and **227**.

As shown in FIG. **14**, a schematic view of a bottom layer of a second switch of a variable attenuator of a second embodiment of the invention, and it is a top view of FIG. **13**.

Multiple conductive sheets **226**, **227** and **233**, and a transition hole **234** are disposed on a bottom layer of the insulator **24**. The conductive sheet **233** operates to shorten the first serial resistor **229**, and the conductive sheets **226** and **227** are connected to the insulator **24** via through holes **234**.

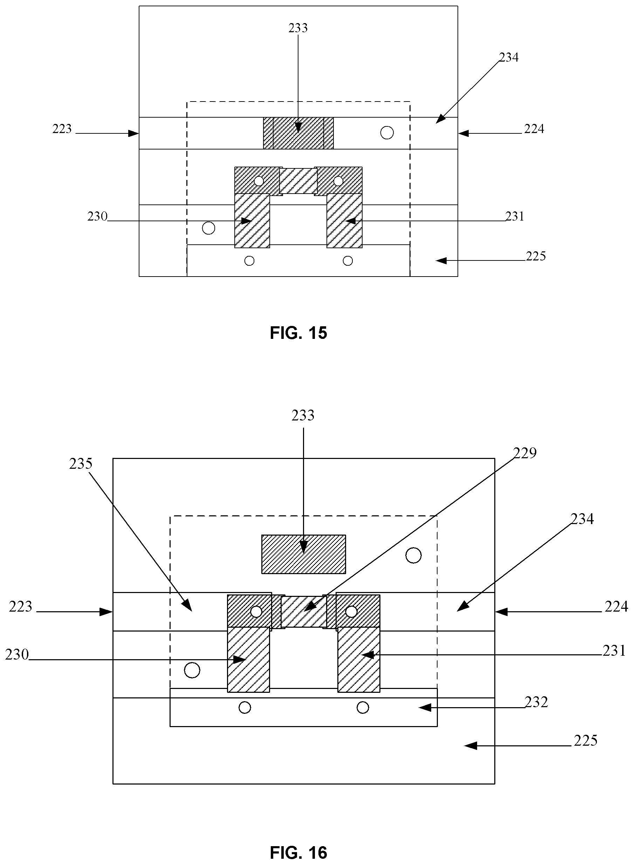

As shown in FIG. **15**, a first combination of a second switch in FIGS. **13** and **14** with a surface layer of a second substrate is shown.

The bottom layer of the insulator **24** is contacted with a surface layer of the substrate **23** in FIG. **12**. The conductive sheet **233** shortens the first serial resistor **229**, and the first parallel resistor **230**, the second parallel resistor **231**, the first serial resistor **229**, the first serial switch **226**, and the second serial switch **227** are disconnected from the main signal circuit.

As shown in FIG. **16**, a second combination of a second switch in FIGS. **13** and **14** with a surface layer of a second substrate is shown.

By moving the insulator **24** via the transition hole **234**, the conductive sheet **233** is disconnected from the main signal circuit. At this time one end of the conductive sheet **226** is connected to a signal microstrip line **235** of the substrate **23**, one end of the conductive sheet **227** is connected to another signal microstrip line **234** of the substrate **23**, and thus the first serial resistor **211** is connected to the main signal circuit, the first parallel resistor **230** and the second parallel resistor **231** are connected to the main signal circuit, and a π-type attenuator circuit is formed. Moreover, to ensure that no signal interruption occurs and no signal reflection that may damage a circuit on a previous stage is generated during variation of attenuation of the attenuator, the conductive sheet **226** is connected to the signal microstrip line **235** and the conductive sheet **227** is connected to the signal microstrip line **234** before the conductive sheet **233** is disconnected from the signal microstrip lines **234** and **235**.

The variable attenuator of a first embodiment of the invention has better heat dissipation performance and worse RF and attenuation performance than that of a second embodiment. Positions of resistors and materials of the substrate can be selected as required. Moreover, to facilitate better heat dissipation, heat conduct glue is added in the vicinity of the signal input end and the signal output end, or between the main signal circuit and the common grounded end, whereby facilitating heat dissipation and having no significant effect on RF performance of the attenuator.

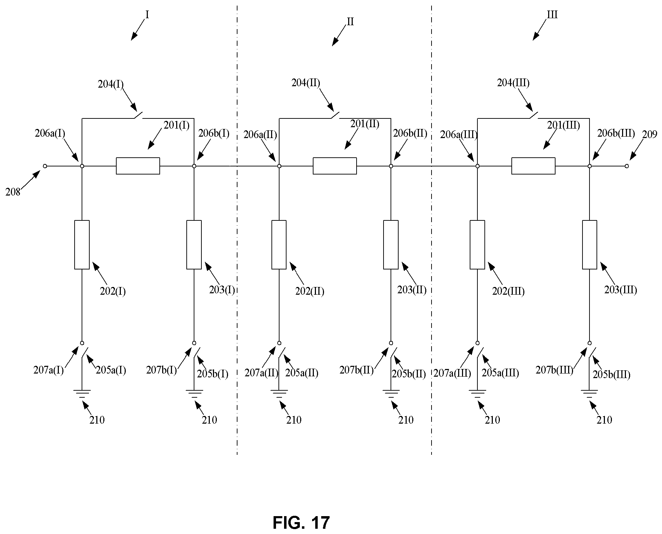

A multi-stage π-type attenuator circuit can be obtained if multiple above-mentioned π-type attenuator circuits are serially connected, and a step amplitude of each stage can be freely set. Switches on each stage of the multi-stage π-type attenuator circuit can be independent from each other, and disposed on at least one insulator (such as a PCB board). Preferably, switches parallel connected to serial resistors and those serially connected to parallel resistors are disposed on the same insulator. FIG. **17** is a schematic diagram of a variable attenuator of a third embodiment of the invention.

A three-stage π-type attenuator circuit is formed by three π-type attenuator circuits I, II and III serially connected to each other. The circuit comprises a first first-stage serial resistor **201(I)**, a first second-stage serial resistor **201(II)**, a first third-stage serial resistor **201(III)**, a first first-stage parallel switch **204(I)** disposed between two terminals **206a(I)** and **206b(I)** of the first first-stage serial resistor **201(I)**, a first second-stage parallel switch **204(II)** disposed between two terminals **206a(II)** and **206b(II)** of the first second-stage serial resistor **201(II)**, a first third-stage parallel switch **204(III)** disposed between two terminals **206a(III)** and **206b(III)** of the first third-stage serial resistor **201(III)**, a first first-stage parallel resistor **202(I)**, a second first-stage parallel resistor **203(I)**, a first second-stage parallel resistor **202(II)**, a second second-stage parallel resistor **203(II)**, a first third-stage parallel resistor **202(III)**, a second third-stage parallel resistor **203(III)**, a first first-stage serial switch **207a(I)** disposed between the first first-stage parallel resistor **202(I)** and a common grounded end **210**, a second first-stage serial switch **207b(I)** disposed between the second first-stage parallel resistor **203(I)** and the common grounded end **210**, a first second-stage serial switch **207a(II)** disposed between the first second-stage parallel resistor **202(II)** and the common grounded end **210**, a second second-stage serial switch **207b(II)** disposed between the second second-stage parallel resistor **203(II)** and the common grounded end **210**, a first third-stage serial switch **207a(III)** disposed between the first third-stage parallel resistor **202(III)** and the common grounded end **210**, a second third-stage serial switch **207b(III)** disposed between the second third-stage parallel resistor **203(III)** and the common grounded end **210**. Operation principle of each stage is the same as that in the first embodiment, and will not be described hereinafter. In this embodiment, all stages can be independent from each other, attenuation can be set freely or according to a fixed step amplitude. All the switches can be disposed on the same insulator (such as a PCB board), or on different insulators.

Since variable attenuators are widely used for adjusting power of a system, attenuation of 0 dB greatly affects the system, a fixed attenuator is added to a front end or a rear end, or between different stages of the variable attenuator.

In another embodiment, the first parallel resistor, the second parallel resistor, the first serial switch, the second serial switch, and the first parallel switch are disposed on the insulator, and the first serial resistor is disposed on the substrate, the principle is the same as the first embodiment, and will not be described hereinafter.

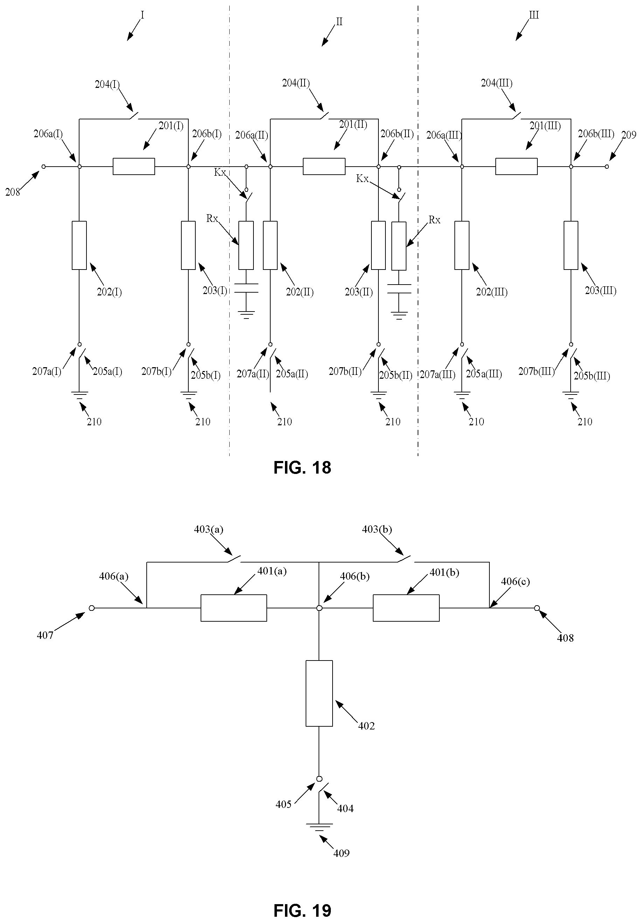

For an attenuator with large attenuation such as 0 - 60 dB, attenuation is constant as a radio frequency is below **4** GHz, and decreases the radio frequency exceeds **4** GHz. To solve this problem, a correcting circuit is added to the circuit in FIG. **17** (as shown in FIG. **18**). Only parts of components relevant to this embodiment are illustrated for the purpose of clear explanation. In other embodiments, the correcting circuit can be added to other variable attenuators.

A correcting circuit is added to one end or both ends of the at least one-stage attenuator (the three-stage attenuator in this embodiment). The correcting circuit comprises a third parallel resistor Rx and a circuit switch Kx. One end of the third parallel resistor Rx is serially connected to the circuit switch Kx, and the other end thereof is connected to a microstrip terminal or to the ground. The microstrip terminal is not connected to other circuits, and microstrip terminals with different dimension are equivalent to capacitors or inductors. The other end of the circuit switch Kx is connected to the signal input end or the signal output end, or between cascades of each stage on the main signal circuit, and operates along with the serial switch connected to the attenuator circuit. In another embodiment, the correcting circuit comprises a third parallel resistor Rx, a circuit switch Kx, and a capacitor (or an inductor). One end of the correcting circuit is connected to the signal input end or the signal output end, or between cascades of each stage on the main signal circuit via the circuit switch Kx. The other end thereof is connected to the ground via the capacitor (or the inductor). The third parallel resistor Rx is connected between the circuit switch Kx and the capacitor (or the inductor), and operates along with the serial switch connected to the attenuator circuit. For example, the correcting circuit is disposed on an insulator (such as a PCB board) with one end thereof connected to a microstrip terminal (such as a microstrip line on the PCB board), and moves along with the insulator. In another embodiment, the other end thereof is connected to another circuit or the ground. As the parallel switch of the attenuator circuit is switched off, the circuit switch Kx is connected to the main signal circuit, and the microstrip terminal connected to the correcting circuit is not connected to any other circuits. At this time the microstrip terminal is equivalent to a RF capacitor or inductor. The correcting circuit is capable of improving frequency performance and attenuation of the attenuator whereby increasing overall attenuation thereof. The correcting circuit is connected to both ends of an attenuator on a certain stage of the variable attenuator. As shown in the equivalent circuit diagram in FIG. **18**, the correcting circuit comprises the circuit switch Kx, the third parallel resistor Rx, and the capacitor.

As shown in FIG. **19**, a schematic diagram of a variable attenuator of a fourth embodiment of the invention is shown.

A first parallel switch **403(a)** is parallel connected between both terminals **406(a)** and **406(b)** of a first serial resistor **401(a)**, a second parallel switch **403(b)** is parallel connected between both terminals **406(b)** and **406(c)** of a second serial resistor **401(b)**, and a first serial switch **404** is serially connected between a terminal **405** of the first parallel resistor **402** and a common grounded end **409**. In other embodiment, the first serial switch **404** is serially connected to the other end of the first parallel resistor **402**.

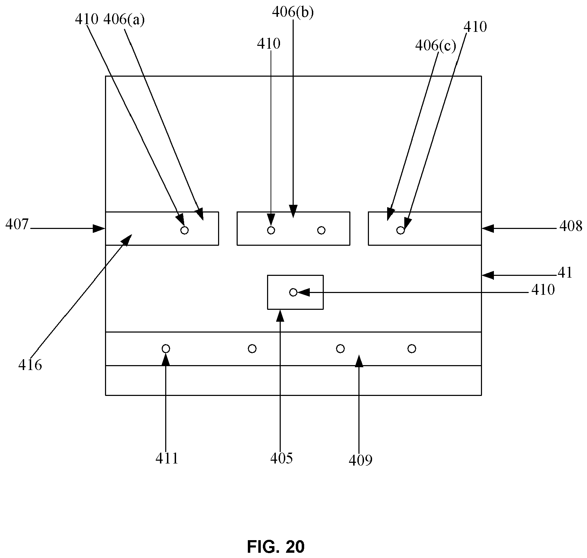

As shown in FIG. **20**, a schematic view of a surface layer of a substrate of a variable attenuator of a fourth embodiment of the invention is shown.

A substrate **41** is a four-layer RF PCB board. In other embodiments, other number of layers, such as one, two or more may be used, and the substrate **41** can be made of other materials such as ceramics. A first layer of the PCB board is a surface layer, a signal input end **407** on the surface layer is connected to a terminal **406(a)** via a signal microstrip line **416**, and a signal output end **408** is connected to a terminal **406(c)** via the signal microstrip line **416**. A pair of terminals **406(a)** and **406(b)** of a first serial resistor **401(a)**, a pair of terminals **406(b)** and **406(c)** of a second serial resistor **401(b)**, a terminal **405** of a first parallel resistor **402**, a common grounded end **409**, multiple terminals **406(a)**, **406(b)**, **406(c)** and **405** are respectively connected to corresponding terminals on a bottom layer via a signal through hole **410**. The common grounded end **409** is connected to a common grounded end on the bottom layer, and to two intermediate metal grounded layers via grounded through holes **411**.

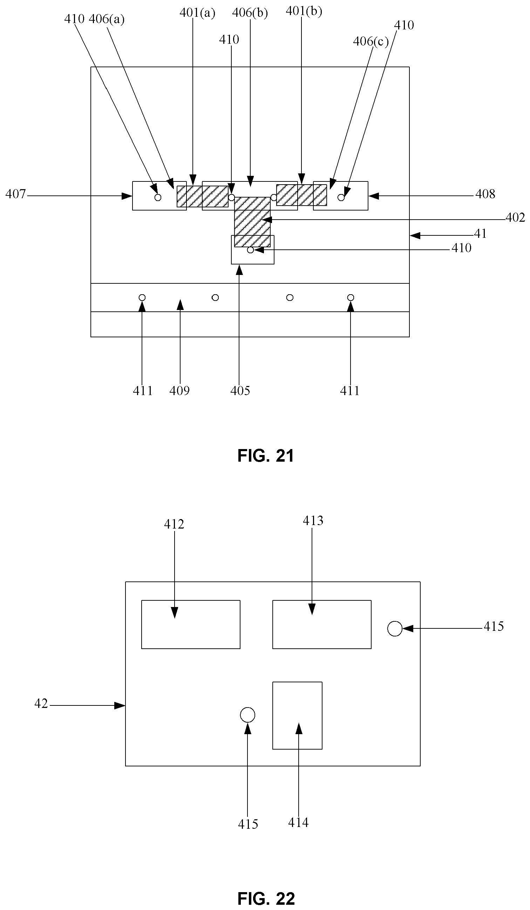

As shown in FIG. **21**, a schematic view of a bottom layer of a substrate of a variable attenuator of a fourth embodiment of the invention is shown.

A first serial resistor **401(a)**, a second serial resistor **401(b)**, and a common grounded end **409** are disposed on the bottom layer of the substrate **41**, one end of the first serial resistor **401(a)** is connected to the terminal **406(a)**, and the other end thereof is connected to the terminal **406(b)**. One end of the second serial resistor **401(b)** is connected to the terminal **406(b)**, and the other end thereof is connected to the terminal **406(c)**. One end of the first parallel resistor **402** is connected to the terminal **406(b)**, and the other end thereof is connected to the terminal **405**.

As shown in FIG. **22**, a schematic view of a switch of a variable attenuator of a fourth embodiment of the invention is shown.

The switch of the variable attenuator is a toggle switch implemented via a conductive sheet, so as to save cost and to make it possible for the first serial resistor, the second serial resistor and the first parallel resistor to be smoothly connected to the main signal circuit as the first parallel switch, the second parallel switch and the first serial switch are switched. A width of the conductive sheet is the same as a bandwidth whereby obtaining an optimum attenuation. In another embodiment, the switch may be a rotary switch implemented by a conductive sheet. The conductive sheets are made of conductive materials such as conductors, and disposed on the same insulator **42** so that the first parallel switch, the first serial switch and the second serial switch operate simultaneously. In another embodiment, the first parallel switch, the first serial switch and the second serial switch are disposed on different insulators. The insulator **42** is a single-layered PCB board. In other embodiments, the insulator **42** is made of plastics, metal, ceramics and so on. Three conductive sheets **412**, **413** and **414** are disposed on the insulator **42**. The conductive sheet **413** operates as a first parallel switch of the first serial resistor **401(a)**, the conductive sheet **412** operates as a second parallel switch of the second serial resistor **401(b)**, and the conductive sheet **414** operates as a first serial switch of the first parallel resistor **402**. A transition hole **415** operates to move the PCB board. A width of each of the conductive sheets **412** and **413** is the same as that of a signal microstrip line, and the conductive sheets **412** and **413** should be long enough to shorten the first serial resistor and the second serial resistor, respectively.

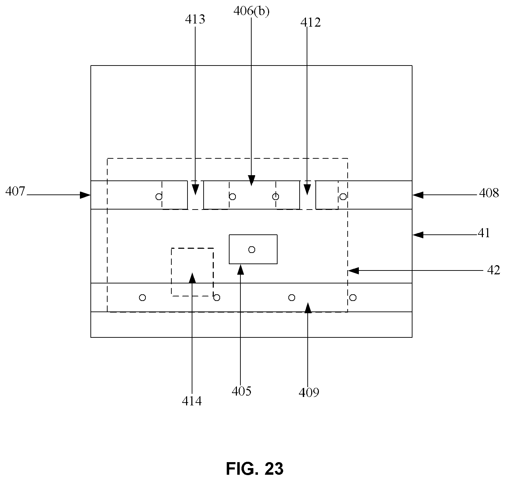

As shown in FIG. **23**, a combination of the switch in FIG. **22** with a substrate is shown.

A first parallel switch, a second parallel switch and a first serial switch on the PCB board, and a first parallel resistor, a first serial resistor and a second serial resistor on the bottom layer of the substrate can be disposed on the same layer or different layers. In this embodiment, the first parallel switch, the second parallel switch and the first serial switch on the PCB board, and the first parallel resistor, the first serial resistor and the second serial resistor on the bottom layer of the substrate can be disposed on different layers. A part indicated by a dashed line illustrates a PCB board in FIG. 22 (rotating by **180** degrees) on the substrate **41**. A side of the PCB board on which the metal conductive sheet is disposed is contacted with the surface layer of the substrate **41**. The terminals **406(a)** and **406(b)** are shortened by the conductive sheet **413**, namely the parallel switch parallel connected to the first serial resistor **401(a)** is switched on, and the terminals **406(b)** and **406(c)** are shortened by the conductive sheet **412**, namely the parallel switch parallel connected to the second serial resistor **401(b)** is switched on. At this time, the conductive sheets **414** are not contacted with the terminal **405**, namely the serial switch **404** is switched off, and attenuation of the variable attenuator is **0**dB. When moving the PCB board so that the conductive sheet **413** detaches from the terminal **406(a)** and the conductive sheet **412** detaches from the terminal **406(b)**, namely switches connected to the first serial resistor **401(a)** and the second serial resistor **401(b)** are switched off. At this time, the conductive sheet **414** is contacted with the terminal **405**, namely the serial switch connected to the first parallel resistor **402** is switched on, attenuation of the variable attenuator is equal to a predetermined value, and thus variation of the attenuation is realized, and the process is reversible.

A multi-stage T-type attenuator circuit (variable attenuator) can be obtained if multiple above-mentioned T-type attenuator circuits are serially connected, switches on each stage of the multi-stage T-type attenuator circuit can be independent from each other, and disposed on at least one insulator (such as a PCB board). The principle is the same as the second embodiment.

In another embodiment, the first parallel resistor, the first serial switch, the first parallel switch, and the second parallel switch are disposed on the insulator, and the first serial resistor and the second serial resistor are disposed on the substrate. The principle is the same as the first embodiment, and will not be described hereinafter.

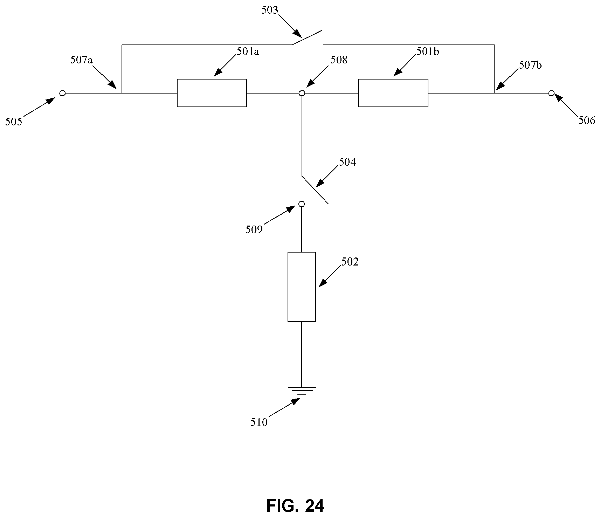

As shown in FIG. **24**, a schematic diagram of a variable attenuator of a fifth embodiment of the invention is shown.

A first parallel switch **503** is parallel connected between one end of the first serial resistor **501a** and one end of the second serial resistor **501b**. The first parallel switch **503** is the same as the switches **412** and **413** in FIG. **19**. A first serial switch **504** is serially connected between terminals **508** and **509** of the first parallel resistor **502**. In another embodiment, the switch **504** is serially connected to the other end of the first parallel resistor **502**.

A multi-stage T-type attenuator circuit can be obtained if multiple above-mentioned T-type attenuator circuits are serially connected, and a step amplitude of each stage can be freely set. Switches on different stages are independent from each other, or disposed on at least one insulator (PCB board).

In another embodiment, the first parallel resistor, the first serial switch, and the first parallel switch are disposed on the insulator, and the first serial resistor and the second serial resistor are disposed on the substrate. The principle is the same as the first embodiment, and will not be described hereinafter.

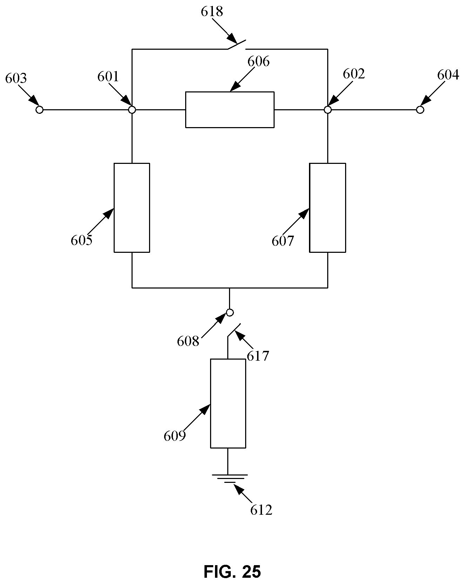

As shown in FIG. **25**, a schematic diagram of a variable attenuator of a sixth embodiment of the invention is shown.

A bridge-type attenuator circuit is shown. A parallel switch **618** is parallel connected between both terminals **601** and **602** of a serial resistor **609**. A bridge-arm resistor **605** is connected to a terminal **601** of the serial resistor **609**. Another bridge-arm resistor **607** is connected to a terminal **602** of the serial resistor **609**. The other end of each of the bridge-arm resistors **605** and **607** is connected to a connecting point. The connecting point is connected to a closed contact **608** on one end of a serial switch **617**, and the other end of the serial switch **617** is connected to a parallel resistor **609**. The other end of the parallel resistor **609** is connected to a common grounded end **612**. In another embodiment, the serial switch **617** is disposed between the parallel resistor **609** and the common grounded end **612**.

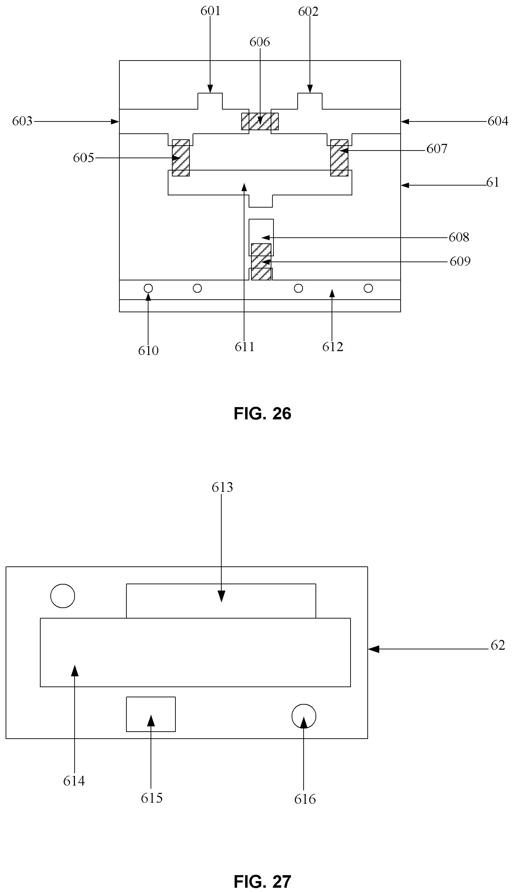

As shown in FIG. **26**, a schematic view of a surface layer of a substrate of a variable attenuator of a sixth embodiment of the invention is shown.

The substrate **61** is a double-layered PCB board. In other embodiments, the substrate **61** may be made of other materials such as ceramics and so on. A signal input end **603**, a signal output end **604**, a serial resistor **606**, a pair of resistors **605** and **607** each having a resistance of **50** ohm, and a parallel resistor **609**.are disposed on a surface of the PCB board. Both terminals **601** and **602** of the serial resistor **606** are connected to the signal input end **603** and the signal output end **604** via signal microstrip lines. One end of the resistor **605** is connected to the signal input end **603**, the other end thereof is connected to a terminal **611**. One end of the resistor **607** is connected to the signal output end **604**, and the other end thereof is connected to the terminal **611**.A terminal **608** of the parallel resistor **609** is serially connected to a switch and then to the terminal **611**. The other end of the parallel resistor **609** is connected to a common grounded end **612**. In another embodiment, the switch is connected to the other end of the parallel resistor **609**, namely between the parallel resistor **609** and the common grounded end **612**. In a further embodiment, a pair of switches are connected to the resistors **605** and **607** whereby replacing the switch serially connected to the parallel resistor **609**, and another switch is parallel connected between both ends of the serial resistor **606**. The common grounded end **612** is connected to a metal plate on the bottom layer of the substrate via a grounded through hole **610**. It should be noted that all the resistors can be disposed on the bottom layer of the substrate, or parts of the resistors are disposed on the bottom layer and the rest of the resistors are disposed on a surface layer of the insulator.

As shown in FIG. **27**, a schematic view of a switch of a variable attenuator of a sixth embodiment of the invention is shown.

Parallel switches and serial switches of the variable attenuator are toggle switches implemented via conductive sheets, so as to save cost and to make it possible for the serial resistors and the parallel resistors to be smoothly connected to the main signal circuit as the parallel switches and the serial switches are switched. A width of the conductive sheet is the same as a bandwidth whereby obtaining an optimum attenuation. In another embodiment, the switch may be a rotary switch implemented by a conductive sheet. The conductive sheets are made of conductive materials such as conductors, and disposed on the same insulator **62** so that the parallel switches and the serial switches operate simultaneously. In another embodiment, the parallel switches and the serial switches are disposed on different insulators. The insulator **62** is a PCB board. The conductive sheet **613** operates as a parallel switch of the serial resistor **606**, a width of each of the conductive **613** is the same as that of a signal microstrip line, and the conductive sheet **613** should be long enough to shorten the terminals **601** and **602**. The conductive sheet **615** operates as a serial switch of the parallel resistor **609**. A side of the PCB board on which the conductive sheet is disposed on is contacted with the surface layer of the substrate **61**. The PCB board is contacted with the serial resistor **606** and the resistor having a resistance of **50** ohm whereby preventing the conductive sheet from moving. A slot **614** and a transition hole **616** are disposed on the PCB board.

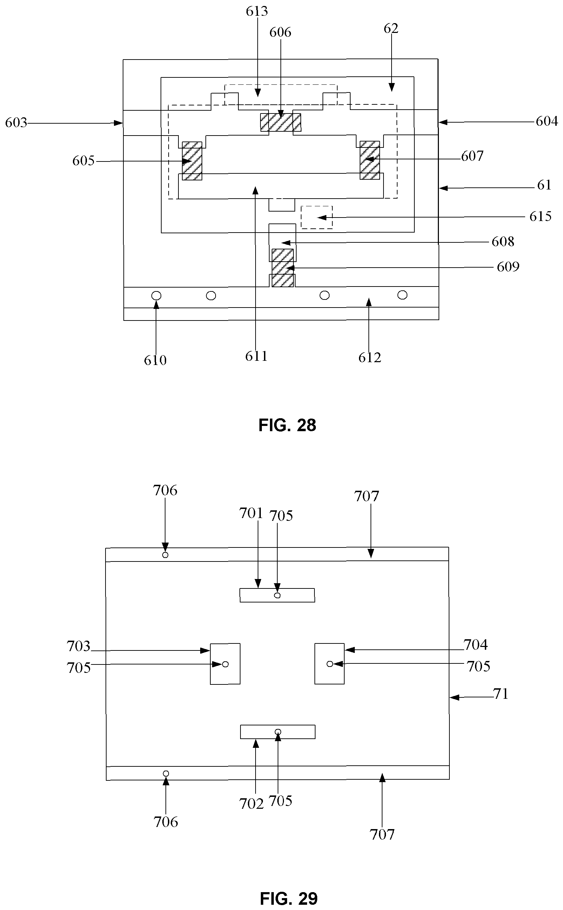

As shown in FIG. **28**, a combination of the switch in FIG. **27** with a substrate is shown.

A part indicated by a dashed line illustrates a PCB board **62** in FIG. **27** (rotating by **180** degrees) on the substrate **61**. The serial resistor **606** is shortened by the conductive sheet **613**, the parallel resistor **609** is not connected to the main signal circuit, namely signal is directly transmitted from the signal input end to the signal output end. At this time, attenuation of the variable attenuator is **0**dB. As the PCB board **62** is moved to the left so that the conductive sheet **613** detaches from the terminal **602** of the serial resistor **606** and at the same time the conductive sheet **615** is connected to the terminal **611** of the parallel resistor **609**. Thus a typical bridge-type attenuator circuit with designed attenuation is formed. If resistance of the serial resistor **606** is **21** ohm, and that of the parallel resistor **609** is **121** ohm, a variable attenuator having attenuation changing from **0** dB to **3** dB is formed, and the variation process is reversible.

A multi-stage variable attenuator can be obtained if multiple above-mentioned attenuator circuits are serially connected, and a step amplitude of each stage can be freely set. Switches on different stages are independent from each other, and all the switches can be disposed on at least one insulator (PCB board).

It should be noted that as a multi-stage attenuator can be formed by attenuator circuits of the same type, or by different types of attenuator circuits, for example, π-type attenuator circuits and T-type attenuator circuits serially connected to each other, T-type attenuator circuits and π-type attenuator circuits serially connected to each other, and so on.

In this embodiment, the serial switches, the parallel resistors and the parallel switches are disposed on the insulator, and the serial resistors are disposed on the substrate. The principle is the same as the first embodiment, and will not be described hereinafter.

As shown in FIG. **29**, a schematic view of a surface layer of a substrate of a variable attenuator of a seventh embodiment of the invention is shown.

A substrate **71** is a double-layered RF ceramic substrate. In other embodiments, other number of layers can also be used, and the substrate **71** can be a PCB board and so on. Four terminals **701**, **702**, **703** and **704** are disposed on a surface layer of the substrate **71**, and connected to corresponding terminals on a bottom layer thereof via a signal through hole **705**, respectively. A common grounded end **707** is disposed on the surface layer thereof, and connected to a grounded end on the bottom layer thereof via a grounded through hole **706**.

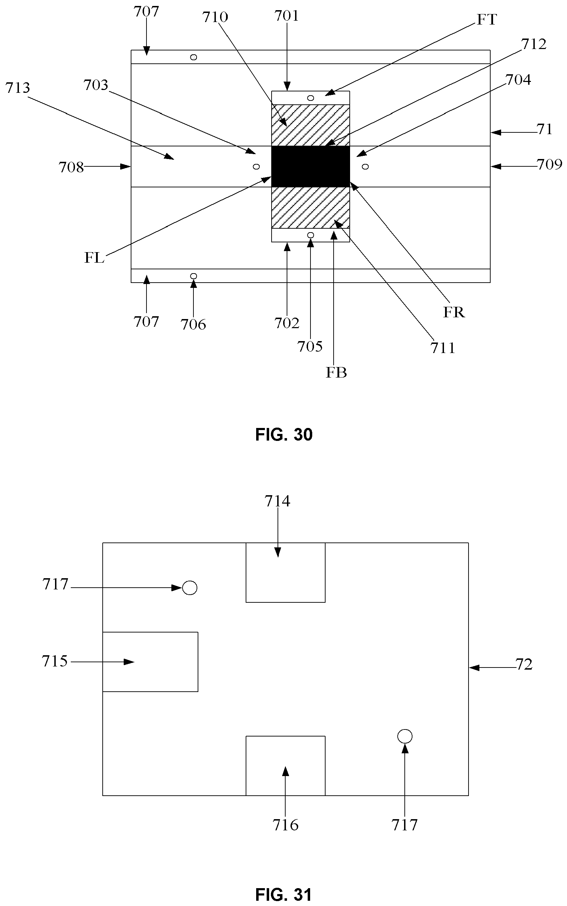

As shown in FIG. **30**, a schematic view of a bottom layer of a substrate of a variable attenuator of a seventh embodiment of the invention is shown.

A signal input end **708**, a signal output end **709**, a first serial resistor **712**, a first parallel resistor **710**, a second parallel resistor **711**, and a common grounded end **707** are disposed on a substrate **71**. The first serial resistor **712**, the first parallel resistor **710**, and the second parallel resistor **711** are film resistors. Film resistors refer to resistors that are made by a thick film process or a thin film process. In principle, before protecting layer is coated, four sides of the film resistor can be electrically connected to each other. The signal input end **708** is connected to a terminal **703** via a signal microstrip line **713**, the terminal **703** is connected to one side (left side) FL of the first serial resistor **712**, the other side (right side) FR of the first serial resistor **712** is connected to a terminal **704**, the terminal **704** is connected to the signal output end **709** via the signal microstrip line **713**. An upper side of the first serial resistor **712** is connected to one end of the first parallel resistor **710**, and the other end FT (upper end) of the first parallel resistor **710** is connected to a terminal **701**. A bottom side of the first serial resistor **712** is connected to one end of the second parallel resistor **711**, and the other end FB (lower end) of the second parallel resistor **711** is connected to a terminal **702**. Both ends of the first serial resistor **712** are respectively connected to the signal input end **708** and the signal output end **709**. The first serial resistor **712**, the first parallel resistor **710**, and the second parallel resistor **711** can be integrally formed and not be made separately

As shown in FIG. **31**, a schematic view of a switch of a variable attenuator of a seventh embodiment of the invention is shown.

Switches of the variable attenuator are toggle switches implemented via conductive sheets, so as to save cost and to make it possible for the first serial resistor, the first parallel switch and the second parallel resistor to be smoothly connected to the main signal circuit as the first parallel switch, the first serial switch and the second serial switch are switched. A width of the conductive sheet is the same as a bandwidth whereby obtaining an optimum attenuation. In another embodiment, the switch may be a rotary switch implemented by a conductive sheet. The conductive sheets are made of conductive materials such as conductors, and disposed on the same insulator **72** so that a switch of the first serial resistor and switches of the first parallel resistor and the second parallel resistor operate simultaneously. In another embodiment, all the switches are disposed on different insulators. The insulator **72** is a PCB board. The conductive sheet **715** is connected to terminals **703** and **704**, and operates as a parallel switch of the first serial resistor **712**. The conductive sheet **714** is connected to a terminal **701** and a common grounded end **707**, and operates as a switch to serially connect the first parallel resistor **701** to the common grounded end **707**. The conductive sheet **716** is connected to a terminal **702** and the common grounded end **707**, and operates as a switch to serially connect the second parallel resistor **702** to the common grounded end **707**. A transition hole **717** operates to move the PCB board.

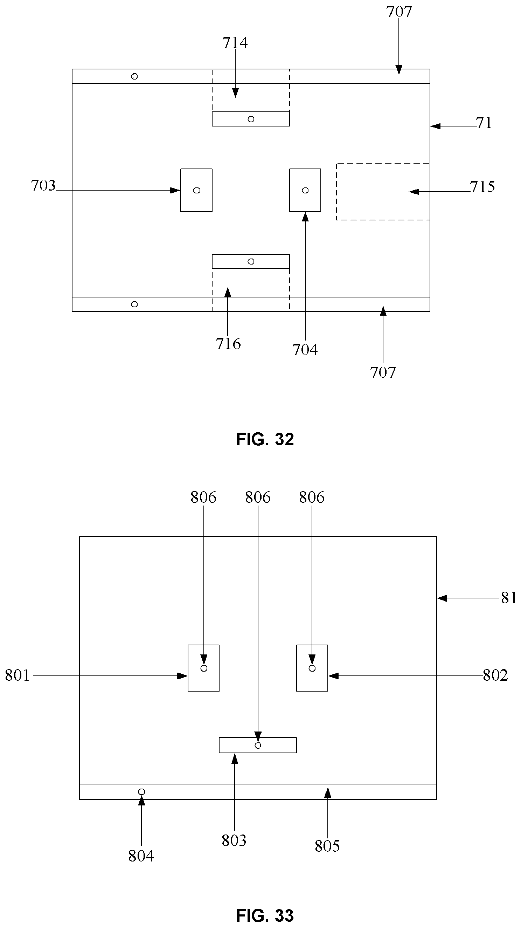

As shown in FIG. **32**, a combination of the switch in FIG. **31** with a substrate is shown.

A part indicated by a dashed line illustrates a PCB board in FIG. **31** (rotating by **180** degrees) on the substrate **71**. A side of the PCB board on which a conductive sheet is disposed on is contacted with the surface layer of the substrate **71**. The conductive sheet **714** connects the terminal **701** of the first parallel resistor **710** to the common grounded end **707**, namely the serial switch connected to the first parallel resistor **710** is switched on. The conductive sheet **716** connects the terminal **702** of the second parallel resistor **711** to the common grounded end **709**, namely the serial switch connected to the second parallel resistor **711** is switched on. At this time, the parallel switch connected to the first serial resistor **712** is switched off, and the variable attenuator is a typical film attenuator, and attenuation thereof can be determined according to design requirement. As the PCB board is moved from right to left, both ends **703** and **704** (FL and FR) of the first serial resistor **712** are shortened by the conductive sheet **715**, namely the parallel switch connected to the first serial resistor **712** is switched on. At this time, the conductive sheet **714** detaches from the terminal **701**, namely the serial switch connected to the first parallel resistor **710** is switched off, the conductive sheet **716** detaches from the terminal **702**, namely the serial switch connected to the second parallel resistor **711** is switched off, and attenuation of the variable attenuator is **0** dB. Thus variation of attenuation of the variable attenuator (from a step amplitude to **0** dB) is facilitated.

A multi-stage variable attenuator can be obtained if multiple above-mentioned attenuator circuits are serially connected, and a step amplitude of each stage can be freely set. Switches on different stages are independent from each other, and all the switches can be disposed on at least one insulator (PCB board). The first serial resistor **712**, the first parallel resistor **710**, and the second parallel resistor **711** are integrally formed into a film resistor. The variable attenuator is equivalent to several π-type attenuators that are serially connected, and finally to a π-type attenuator circuit.

In this embodiment, the first parallel resistor **710**, the second parallel resistor **711**, the first serial switch, the second serial switch, and the first parallel switch are disposed on the same insulator, and the first serial resistor **712** is disposed on the substrate. The principle is the same as the first embodiment, and will not be described hereinafter.

As shown in FIG. **33**, a schematic view of a surface layer of a substrate of a variable attenuator of an eighth embodiment of the invention is shown.

A substrate **81** is a double-layered RF ceramic substrate. In other embodiments, the substrate **81** can be a PCB board and so on. Three terminals **801**, **802**, and **803** are disposed on a surface layer of the substrate **81**, and connected to corresponding terminals on a bottom layer thereof via a signal through hole **806**, respectively. A common grounded end **805** is disposed on the surface layer thereof, and connected to a grounded end on the bottom layer thereof via a grounded through hole **804**.

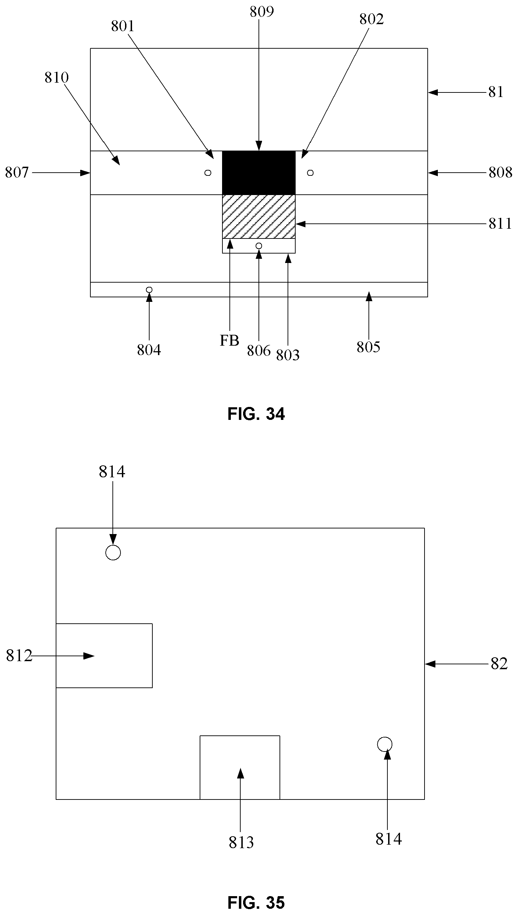

As shown in FIG. **34**, a schematic view of a bottom layer of a substrate of a variable attenuator of an eighth embodiment of the invention is shown.

A signal input end **807**, a signal output end **808**, a first serial resistor **809**, a first parallel resistor **811**, and a common grounded end **805** are disposed on the substrate **81**. The first serial resistor **809** and the first parallel resistor **811** are film resistors. Film resistors refer to resistors that are made by a thick film process or a thin film process. In principle, before protecting layer is coated, four sides of the film resistor can be electrically connected to each other. The signal input end **807** is connected to a terminal **801** via a signal microstrip line **810**, the terminal **801** is connected to one side (left side) of the first serial resistor **809**, the other side (right side) of the first serial resistor **809** is connected to a terminal **802**, the terminal **802** is connected to the signal output end **808** via the signal microstrip line **810**. A lower side of the first serial resistor **809** is connected to one end of the first parallel resistor **811**, and the other end (lower end) of the first parallel resistor **811** is connected to a terminal **803**. Both ends of the first serial resistor **809** are respectively connected to the signal input end **807** and the signal output end **808**. The first serial resistor **809** and the first parallel resistor **811** can be integrally formed.

As shown in FIG. **35**, a schematic view of a switch of a variable attenuator of an eighth embodiment of the invention is shown.

Switches of the variable attenuator are toggle switches implemented via conductive sheets, so as to save cost and to make it possible for the first serial resistor **809** and the first parallel resistor **811** to be smoothly connected to the main signal circuit as the first parallel switch and the first serial switch are switched. A width of the conductive sheet is the same as a bandwidth whereby obtaining an optimum attenuation. In another embodiment, the switch may be a rotary switch implemented by a conductive sheet. The conductive sheets are made of conductive materials such as conductors, and disposed on the same insulator **82** so that a switch of the first serial resistor **809** and a switch of the first parallel resistor **811** operate simultaneously. In another embodiment, all the switches are disposed on different insulators. The insulator **82** is a PCB board. All conductive sheets can be disposed on the same PCB board. The conductive sheet **812** is connected to terminals **801** and **802**, and operates as a parallel switch of the first serial resistor **809**. The conductive sheet **813** is connected to a terminal **803** and a common grounded end **805**, and operates as a switch to serially connect the first parallel resistor 811 to the common grounded end 805. A transition hole 814 operates to move the PCB board.

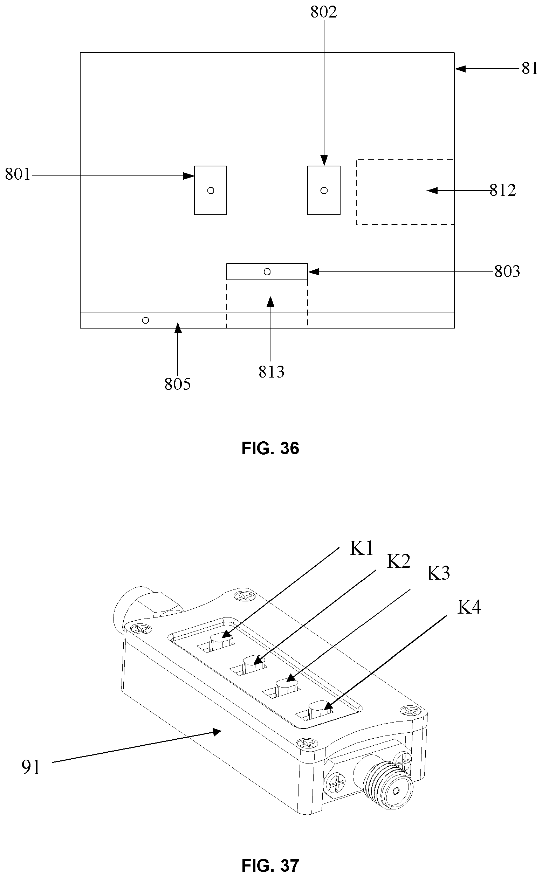

As shown in FIG. 36, a combination of the switch in FIG. 35 with a substrate is shown.

A part indicated by a dashed line illustrates a PCB board in FIG. 35 (rotating by 180 degrees) on the substrate 81. A side of the PCB board on which a conductive sheet is disposed on is contacted with the surface layer of the substrate **81**. The conductive sheet **813** connects the terminal **803** of the first parallel resistor **811** to the common grounded end **805**, namely the serial switch connected to the first parallel resistor **811** is switched on, and the parallel switch connected to the first serial resistor **809** is switched off. At this time, the variable attenuator is a typical film attenuator, and attenuation thereof can be determined according to design requirement. As the PCB board is moved from right to left, both ends **801** and **802** of the first serial resistor **809** are shortened by the conductive sheet **812**, namely the parallel switch connected to the first serial resistor **809** is switched on. At this time, the conductive sheet **813** detaches from the terminal **803**, namely the serial switch connected to the first parallel resistor **811** is switched off, and attenuation of the variable attenuator is **0** dB. Thus variation of attenuation of the variable attenuator is facilitated, and the process is reversible.

A multi-stage variable attenuator can be obtained if multiple above-mentioned attenuator circuits are serially connected, and a step amplitude of each stage can be freely set. Switches on different stages are independent from each other, and all the switches can be disposed on at least one insulator (PCB board). The first serial resistor **809** and the first parallel resistor **811** are integrally formed into a film resistor. The variable attenuator is equivalent to several T-type attenuators that are serially connected, and finally to a T-type attenuator circuit.

In this embodiment, the first parallel resistor, the second serial switch and the first parallel switch are disposed on the same insulator, and the first serial resistor is disposed on the substrate. The principle is the same as the first embodiment, and will not be described hereinafter.

The variable attenuator can be encapsulated via a metal housing connected to a coaxial connector, a coaxial connector, or a plastic surface-mount device (SMD). The coaxial connector can be a SMA-type or a N-type coaxial connector. The switch may be a toggle switch or a rotary switch.

As shown in FIG. **37**, a schematic view of a coaxial connector with a metal housing is shown.

A housing of the variable attenuator is a metal housing **91**, a pair of SMA coaxial fitting is disposed on both sides thereof, and four toggle switches **K1**, **K2**, **K3** and **K4** are disposed on the surface thereof and operate to adjust attenuation.

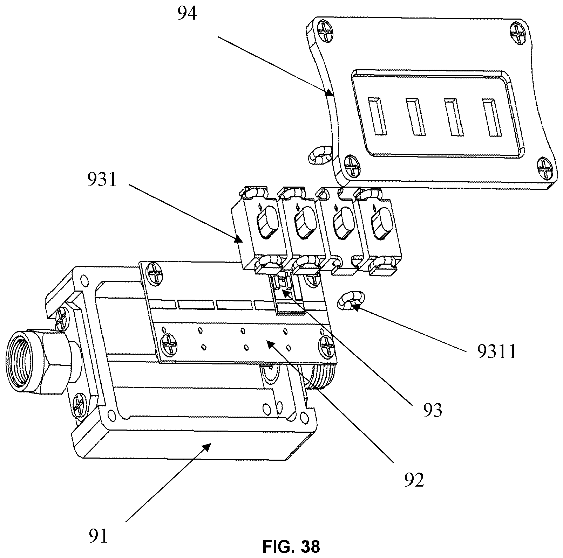

As shown in FIG. **38**, internal structure of FIG. **37** is shown.

A substrate **92** is disposed in the metal housing **91**, an insulator **93** is disposed above the substrate **92**, a post **931** is disposed on the insulator **93**, a pair of silicon rubber rings **9311** are disposed on both ends of the **931**, and operate to tightly fix the insulator **93** to the surface layer of the substrate **92**, a metal cover **94** is disposed at the top of the substrate **92** and fixes the silicon rubber rings **9311** via screws.

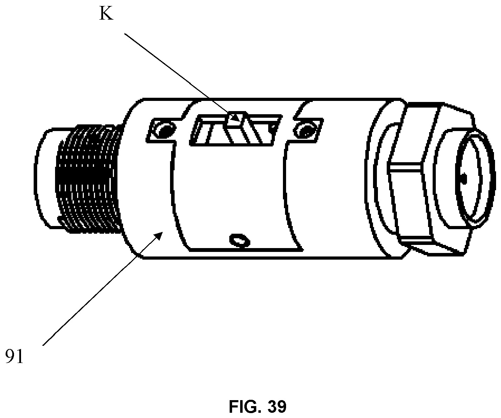

As shown in FIG. **39**, a schematic view of an integral coaxial connector is shown.

A coaxial connector having same structure as that in FIG. **38** can be used to replace the metal housing. In this embodiment, the coaxial connector can be a SMA-type or a N-type coaxial connector, and features convenient use, compact structure, and low cost for mass production.

The invention employs the parallel switch parallel connected to the serial resistor, and the serial switch serially connected to the parallel resistor, as the parallel switch is switched on to eliminate attenuation on a certain stage, the serial switch is switched off, whereby preventing the parallel resistor from affecting the main signal circuit and ensuring stable attenuation with higher precision and a wider frequency range; moreover, switching of the main signal circuit is not required, which ensures that a signal is always transmitted on the main signal circuit and no reflection signal (burst pulse) is generated on the main signal circuit, and thus a circuit on a previous stage will not be damaged.

While particular embodiments of the invention have been shown and described, it will be obvious to those skilled in the art that changes and modifications may be made without departing from the invention in its broader aspects, and therefore, the aim in the appended claims is to cover all such changes and modifications as fall within the scope of the appended claims.

## Claims

1. A variable attenuator, comprising at least one-stage attenuator circuit, the at least one-stage attenuator circuit comprising a signal input end (208 or 212), a signal output end (209 or 213), and a common grounded end (210 or 214), a first serial resistor (201 or 211) being disposed between said signal input end (208 or 212) and said signal output end (209 or 213) whereby forming a main signal circuit, and a first parallel resistor (202 or 217) being connected to said common grounded end (210 or 214);
**characterized in that**
a gap is disposed between said first parallel resistor (202 or 217) and said main signal circuit or is disposed between said first parallel resistor (202 or 217) and said common grounded end (210 or 214);
the at least one-stage attenuator circuit further comprises a first conductive sheet (204 or 221) and a second conductive sheet (205a or 215);
said first conductive sheet (204 or 221) and said second conductive sheet (205a or 215) are movable;
said first conductive sheet (204 or 221) is adapted to be moved into a first position or a second position;
said second conductive sheet (205a or 215) is adapted to be moved into a third position or a fourth position;
when said first conductive sheet (204 or 221) is moved into the first position, said first conductive sheet (204 or 221) is disconnected from said signal input end (208 or 212) and said signal output end (209 or 213); and said second conductive sheet (205a or 215) is simultaneously moved into the third position and bridges the gap, whereby connecting said first parallel resistor (202 or 217) to said common grounded end (210 or 214); and
when said first conductive sheet (204 or 221) is moved into the second position, said first conductive sheet (204 or 221) is connected to said signal input end (208 or 212) and said signal output end (209 or 213), whereby short circuiting said first serial resistor (201 or 211); and said second conductive sheet (205a or 215) is simultaneously moved into the fourth position and is disconnected from said first parallel resistor (202 or 217) and said common grounded end (210 or 214), whereby disconnecting said first parallel resistor (202 or 217) from said common grounded end (210 or 214).

2. The variable attenuator of claim 1, further comprising a substrate (21) and an insulator (22), wherein said first serial resistor (201 or 211), said signal input end (208 or 212), said signal output end (209 or 213), and said common grounded end (210 or 214) are disposed on said substrate (21); and said first conductive sheet (204 or 221), said first parallel resistor (202 or 217), and said second conductive sheet (205a or 215) are disposed on said insulator (22).

3. The variable attenuator of claim 1, wherein the variable attenuator is disposed in a coaxial connector (91).

4. The variable attenuator of claim 1, wherein said first serial resistor (201 or 211) is a chip resistor, a thick film resistor, a thin film resistor, an embedded resistor, a printed resistor, or a combination thereof.

## Patentansprüche

1. Einstellbares Dämpfungsglied, das wenigstens einen einstufigen Dämpfungsgliedkreis umfasst, wobei der wenigstens eine einstufige Dämpfungsgliedkreis ein Signaleingangsende (208 oder 212), ein Signalausgangsende (209 oder 213) und ein gemeinsames geerdetes Ende (210 oder 214) umfasst, ein erster Reihenwiderstand (201 oder 211) zwischen dem Signaleingangsende (208 oder 212) und dem Signalausgangsende (209 oder 213) angeordnet ist, wodurch ein Hauptsignalkreis gebildet wird, und ein erster Parallelwiderstand (202 oder 217) mit dem gemeinsamen geerdeten Ende (210 oder 214) verbunden ist,
**dadurch gekennzeichnet, dass**
ein Spalt zwischen dem ersten Parallelwiderstand (202 oder 217) und dem Hauptsignalkreis angeordnet ist oder zwischen dem ersten Parallelwiderstand (202 oder 217) und dem gemeinsamen geerdeten Ende (210 oder 214) angeordnet ist,
die wenigstens eine einstufige Dämpfungsgliedschaltung ferner eine erste leitfähige Bahn (204 oder 221) und eine zweite leitfähige Bahn (205a oder 215) umfasst,
die erste leitfähige Bahn (204 oder 221) und die zweite leitfähige Bahn (205a oder 215) beweglich sind,
die erste leitfähige Bahn (204 oder 221) dafür eingerichtet ist, in eine erste Stellung oder eine zweite Stellung bewegt zu werden,
die zweite leitfähige Bahn (205a oder 215) dafür eingerichtet ist, in eine dritte Stellung oder eine vierte Stellung bewegt zu werden,
wenn die erste leitfähige Bahn (204 oder 221) in die erste Stellung bewegt wird, die erste leitfähige Bahn (204 oder 221) von dem Signaleingangsende (208 oder 212) und dem Signalausgangsende (209 oder 213) getrennt wird und die zweite leitfähige Bahn (205a oder 215) gleichzeitig in die dritte Stellung bewegt wird und den Spalt überbrückt, wodurch der erste Parallelwiderstand (202 oder 217) mit dem gemeinsamen geerdeten Ende (210 oder 214) verbunden wird, und
wenn die erste leitfähige Bahn (204 oder 221) in die zweite Stellung bewegt wird, die erste leitfähige Bahn (204 oder 221) mit dem Signaleingangsende (208 oder 212) und dem Signalausgangsende (209 oder 213) verbunden wird, wodurch der erste Reihenwiderstand (201 oder 211) kurzgeschlossen wird, und die zweite leitfähige Bahn (205a oder 215) gleichzeitig in die vierte Stellung bewegt wird und von dem ersten Parallelwiderstand (202 oder 217) und dem gemeinsamen geerdeten Ende (210 oder 214) getrennt wird, wodurch der erste Parallelwiderstand (202 oder 217) von dem gemeinsamen geerdeten Ende (210 oder 214) getrennt wird.

2. Einstellbares Dämpfungsglied nach Anspruch 1, das ferner ein Substrat (21) und einen Isolator (22) umfasst, wobei der erste Reihenwiderstand (201 oder 211), das Signaleingangsende (208 oder 212), das Signalausgangsende (209 oder 213) und das gemeinsame geerdete Ende (210 oder 214) auf dem Substrat (21) angeordnet sind und die erste leitfähige Bahn (204 oder 221), der erste Parallelwiderstand (202 oder 217) und die zweite leitfähige Bahn (205a oder 215) auf dem Isolator (22) angeordnet sind.

3. Einstellbares Dämpfungsglied nach Anspruch 1, wobei das einstellbare Dämpfungsglied in einem Koaxialverbinder (91) angeordnet ist.

4. Einstellbares Dämpfungsglied nach Anspruch 1, wobei der erste Reihenwiderstand (201 oder 211) ein Chipwiderstand, ein Dickschichtwiderstand, ein Dünnschichtwiderstand, ein eingebetteter Widerstand, ein gedruckter Widerstand oder eine Kombination derselben ist.

## Revendications

1. Atténuateur variable, comprenant au moins un circuit d'atténuateur à un étage, l'au moins un circuit d'atténuateur à un étage comprenant une extrémité d'entrée de signal (208 ou 212), une extrémité de sortie de signal (209 ou 213), et une extrémité mise à la masse commune (210 ou 214), une première résistance en série (201 ou 211) étant disposée entre ladite extrémité d'entrée de signal (208 ou 212) et ladite extrémité de sortie de signal (209 ou 213), formant ainsi un circuit de signal principal, et une première résistance en parallèle (202 ou 217) étant reliée à ladite extrémité mise à la masse commune (210 ou 214) ;
**caractérisé en ce que**
un espacement est disposé entre ladite première résistance en parallèle (202 ou 217) et ledit circuit de signal principal ou disposée entre ladite première résistance en parallèle (202 ou 217) et ladite extrémité mise à la masse commune (210 ou 214) ;
l'au moins un circuit d'atténuateur à un étage comprend en outre une première feuille conductrice (204 ou 221) et une deuxième feuille conductrice (205a ou 215) ;
ladite première feuille conductrice (204 ou 221) et ladite deuxième feuille conductrice (205a ou 215) étant déplaçables ;
ladite première feuille conductrice (204 ou 221) étant adaptée pour être déplacée dans une première position ou une deuxième position ;
ladite deuxième feuille conductrice (205a ou 215) étant adaptée pour être déplacée dans une troisième position ou une quatrième position ;
lorsque ladite première feuille conductrice (204 ou 221) est déplacée dans la première position, ladite première feuille conductrice (204 ou 221) est déconnectée de ladite extrémité d'entrée de signal (208 ou 212) et de ladite extrémité de sortie de signal (209 ou 213) ; et ladite deuxième feuille conductrice (205a ou 215) est déplacée simultanément dans la troisième position et comble l'espacement, reliant ainsi ladite première résistance en parallèle (202 ou 217) à ladite extrémité mise à la masse commune (210 ou 214) ; et
lorsque ladite première feuille conductrice (204 ou 221) est déplacée dans la deuxième position, ladite première feuille conductrice (204 ou 221) est reliée à ladite extrémité d'entrée de signal (208 ou 212) et à ladite extrémité de sortie de signal (209 ou 213), court-circuitant ainsi ladite première résistance en série (201 ou 211) ; et ladite deuxième feuille conductrice (205a ou 215) est déplacée simultanément dans la quatrième position et déconnectée de ladite première résistance en parallèle (202 ou 217) et de ladite extrémité mise à la masse commune (210 ou 214), déconnectant ainsi ladite première résistance en parallèle (202 ou 217) de ladite extrémité mise à la masse commune (210 ou 214).

2. Atténuateur variable selon la revendication 1, comprenant en outre un substrat (21) et un isolant (22), dans lequel ladite première résistance en série (201 ou 211), ladite extrémité d'entrée de signal (208 ou 212), ladite extrémité de sortie de signal (209 ou 213) et ladite extrémité mise à la masse commune (210 ou 214) sont disposées sur ledit substrat (21) ; et ladite première feuille conductrice (204 ou 221), ladite première résistance en parallèle (202 ou 217) et ladite deuxième feuille conductrice (205a ou 215) sont disposées sur ledit isolant (22).

3. Atténuateur variable selon la revendication 1, dans lequel l'atténuateur variable est disposée dans un connecteur coaxial (91).

4. Atténuateur variable selon la revendication 1, dans lequel ladite première résistance en série (201 ou 211) est une résistance à puce, une résistance à couche épaisse, une résistance à couche mince, une résistance enrobée, une résistance intégrée, ou une combinaison de celles-ci.
